# EUROPEAN PATENT APPLICATION

(11) **EP 4 325 295 A1**
(43) Date of publication of application: **21.02.2024**
(21) Application number: 22788136.4
(22) Date of filing: 11.04.2022
(51) Int. Cl.: G03F 7/20

(54) **DRAWING DEVICE AND DRAWING METHOD**

(30) Priority: 14.04.2021 JP 2021068429
(71) Applicant: SCREEN Holdings Co., Ltd., Kyoto-shi, Kyoto 602-8585 (JP)
(72) Inventor: MAJIMA, Shota, Kyoto-shi, Kyoto 602-8585 (JP)
(74) Representative: Kilian Kilian & Partner mbB
(86) International application number: PCT/JP2022/017464
(87) International publication number: WO 2022/220211

(57) **Abstract**

An object is to provide a drawing apparatus capable of drawing a pattern with high accuracy on an exposure surface having a height difference exceeding a DOF without requiring complicated adjustment of a focus of an optical system. A drawing pattern includes at least one stepped pattern that is drawn at least partially on an inclined surface of a stepped structure and extends in a longitudinal direction in a plan view, and the drawing apparatus includes: a modulator (44) that has a diffraction grating including a plurality of diffractive elements arrayed in an array direction (GX); a rotation mechanism (21) that rotates a substrate (W) in a horizontal plane; and a controller (60) that controls the rotation mechanism (21) to adjust an orientation of the substrate (W) on the horizontal plane such that the longitudinal direction of the at least one stepped pattern substantially coincides with an orthogonal direction (GY) orthogonal to the array direction (GX) in the plan view.

## Description

### TECHNICAL FIELD

The present invention relates to a drawing apparatus and a drawing method, and more particularly to a drawing apparatus including a modulator having a diffraction grating and a drawing method using the same.

### BACKGROUND ART

As a typical exposure method in photolithography, a method of projecting a pattern of a photomask onto a substrate by an optical system has been widely used. On the other hand, a method of drawing a pattern on a photosensitive surface using a drawing head, in other words, direct drawing is also used, and in this case, there is an advantage that the photomask is not required. As a technique of the direct drawing, for example, Japanese Patent Application Laid-Open No. 2015-170838 (Patent Document 1) discloses an exposure method intended to reduce an exposure defect when a film pattern such as wiring is formed on an inclined surface such as a concave portion or a convex portion. According to the above publication, it is claimed that the reduction of the exposure defect is achieved by controlling a polarization state to suppress stray light. In addition, according to the above publication, it is described that there is a limit to a depth of focus (DOF) of a projection optical system in a case where a fine pattern with high resolution is formed on the inclined surface, and thus, it is necessary to divide one inclined surface into a plurality of exposure regions and expose the fine pattern.

### PRIOR ART DOCUMENT

### PATENT DOCUMENT

Patent Document 1: Japanese Patent Application Laid-Open No. 2015-170838

### SUMMARY

### PROBLEM TO BE SOLVED BY THE INVENTION

With complication of device structures, there is a demand for exposure by the direct drawing on a surface having a stepped structure. A DOF of a drawing apparatus for the direct drawing is typically about several µm to several tens of µm, and in a case where a height difference of the stepped structure greatly exceeds the DOF, a difference between a drawing pattern and a design pattern is likely to increase due to defocus. To cope with such a problem, one inclined surface is divided into the plurality of exposure regions to expose the fine pattern according to the technique of the publication described above. In this method, however, it is necessary to complicatedly adjust focus of an optical system to correspond to each of the regions, and as a result, control of the drawing apparatus becomes complicated. In particular, when the height difference exceeds 100 µm, it is difficult to follow a change in height with a typical autofocus mechanism for the drawing apparatus.

The present invention has been made to solve the above problems, and an object of the present invention is to provide a drawing apparatus and a drawing method capable of drawing a pattern with high accuracy on an exposure surface having a height difference exceeding a DOF without requiring complicated adjustment of a focus of an optical system.

### MEANS TO SOLVE THE PROBLEM

A first aspect is a drawing apparatus that draws at least one drawing pattern on an exposure surface of a substrate, the exposure surface being provided with at least one stepped structure including a step upper surface, a step lower surface having a lower height than the step upper surface, and an inclined surface connecting the step upper surface and the step lower surface to each other, the at least one drawing pattern including at least one stepped pattern drawn at least partially on the inclined surface of the stepped structure, and the at least one stepped pattern extending in a longitudinal direction in a plan view. The drawing apparatus includes: a substrate holding mechanism that holds the substrate on a horizontal plane; a light source; a modulator that includes a diffraction grating including a plurality of diffractive elements arrayed in an array direction and modulates light from the light source; a projection optical system including an objective lens disposed between the exposure surface and the modulator; a rotation mechanism that rotates the substrate in the horizontal plane; and a controller that controls the rotation mechanism to adjust an orientation of the substrate on the horizontal plane such that the longitudinal direction of the at least one stepped pattern substantially coincides with an orthogonal direction orthogonal to the array direction of the diffraction grating in the plan view.

A second aspect is the drawing apparatus of the first aspect, further including an illumination optical system provided between the light source and the diffraction grating, the illumination optical system supplying light from the light source to the diffraction grating as parallel light in the array direction.

A third aspect is the drawing apparatus of the first or second aspect, in which the plurality of diffractive elements is arrayed only in the array direction.

A fourth aspect is the drawing apparatus of any one of the first to third aspects, in which the controller includes an extractor that extracts, as first pattern data, data representing one of the at least one stepped pattern having a longitudinal direction within a first allowable angle range with a first substrate orientation of the substrate as a reference.

A fifth aspect is the drawing apparatus of the fourth aspect, in which the first allowable angle range is ± 10 degrees.

A sixth aspect is the drawing apparatus of the fourth or fifth aspect, in which the extractor extracts, as second pattern data, data representing one of the at least one stepped pattern having a longitudinal direction within a second allowable angle range with a second substrate orientation, different from the first substrate orientation, of the substrate as a reference.

A seventh aspect is the drawing apparatus of the sixth aspect, in which the second substrate orientation is orthogonal to the first substrate orientation.

An eighth aspect is a drawing method of drawing at least one drawing pattern on an exposure surface of a substrate, the exposure surface being provided with at least one stepped structure including a step upper surface, a step lower surface having a lower height than the step upper surface, and an inclined surface connecting the step upper surface and the step lower surface to each other, the at least one drawing pattern including at least one stepped pattern drawn at least partially on the inclined surface of the stepped structure, and the at least one stepped pattern extending in a longitudinal direction in a plan view. The drawing method includes the steps of: (a) holding the substrate on a horizontal plane; (b) adjusting an orientation of the substrate on the horizontal plane; and (c) irradiating, via an objective lens, the exposure surface with light modulated by a modulator which includes a diffraction grating including a plurality of diffractive elements arrayed in an array direction, step (b) being performed such that the longitudinal direction of the at least one stepped pattern substantially coincides with a direction orthogonal to the array direction of the diffraction grating in the plan view.

### EFFECTS OF THE INVENTION

According to each of the above-described aspects, the orientation of the substrate is adjusted such that the longitudinal direction of the at least one stepped pattern substantially coincides with the orthogonal direction orthogonal to the array direction of the diffraction grating in the plan view. As a result, it is possible to draw the pattern with high accuracy on the exposure surface having the height difference exceeding the DOF without requiring the complicated adjustment of the focus of the optical system.

### BRIEF DESCRIPTION OF DRAWINGS

Fig. 1 is a side view schematically illustrating a configuration of a drawing apparatus according to an embodiment.
Fig. 2 is a plan view schematically illustrating a configuration of the drawing apparatus of Fig. 1.
Fig. 3 is a partial cross-sectional view for describing a configuration and an operation principle of a modulator provided in the drawing apparatus of Fig. 1.
Fig. 4 is a partial cross-sectional view for describing the configuration and the operation principle of the modulator provided in the drawing apparatus of Fig. 1.
Fig. 5 is a view schematically illustrating an optical path in an optical unit provided in the drawing apparatus of Fig. 1.
Fig. 6 is a view schematically illustrating the optical path in the optical unit provided in the drawing apparatus of Fig. 1.
Fig. 7 is a block diagram illustrating a hardware configuration of a controller in Fig. 1.
Fig. 8 is a plan view schematically illustrating exposure scanning in a first mode in a drawing method according to the embodiment.
Fig. 9 is a plan view schematically illustrating exposure scanning in a second mode in the drawing method according to the embodiment.
Fig. 10 is a partial plan view illustrating an exposure surface of a substrate.
Fig. 11 is a partial cross-sectional view taken along line XI-XI in Fig. 10.
Fig. 12 is a partial plan view illustrating an example of an apparatus that requires drawing of a stepped pattern.
Fig. 13 is a partial cross-sectional view taken along line XIII-XIII in Fig. 12.
Fig. 14 is a partial cross-sectional view illustrating a modification of Fig. 13.
Fig. 15 is a functional block diagram schematically illustrating the configuration of the controller in Fig. 1.
Fig. 16 is a partial plan view for describing a function of the controller in Fig. 1.
Fig. 17 is a partial plan view for describing the function of the controller in Fig. 1.
Fig. 18 is a flowchart schematically illustrating the drawing method according to the embodiment.
Fig. 19 is a plan view schematically illustrating one step of the drawing method according to the embodiment.
Fig. 20 is a plan view schematically illustrating one step of the drawing method according to the embodiment.
Fig. 21 is a plan view schematically illustrating one step of the drawing method according to the embodiment.
Fig. 22 is a partial cross-sectional view schematically illustrating a state of exposure scanning in a first comparative example.
Fig. 23 is a partial plan view illustrating a resist pattern obtained by the exposure scanning in Fig. 22.
Fig. 24 is a view for describing exposure scanning in a second comparative example.
Fig. 25 is a view for describing exposure scanning in the embodiment.
Fig. 26 is a photomicrograph showing an example of the exposure scanning in Fig. 25.

### DESCRIPTION OF EMBODIMENTS

Hereinafter, embodiments of the present invention will be described with reference to the drawings. Note that the same or corresponding portions in the following drawings will be denoted by the same reference signs, and the description thereof will not be repeated. In addition, an X axis, a Y axis, and a Z axis in an XYZ orthogonal coordinate system are illustrated in some drawings for easy understanding of a directional relationship between the drawings.

### <Drawing Apparatus>

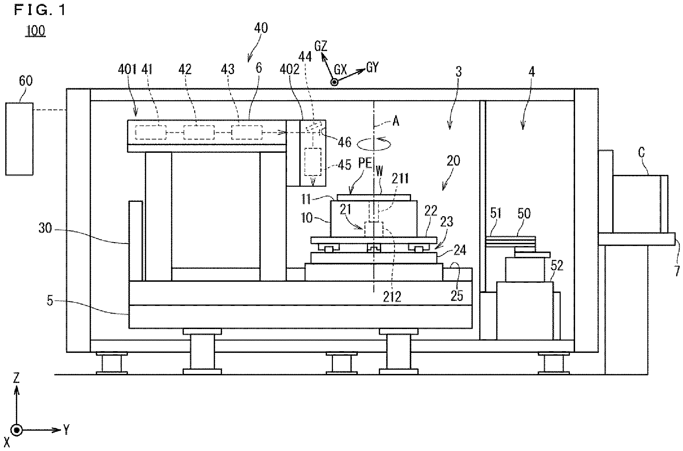

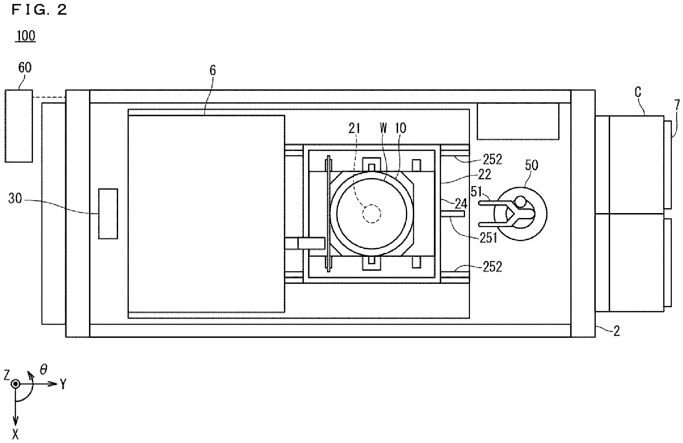

Figs. 1 and 2 are a side view and a plan view, respectively, which schematically illustrate a configuration of a drawing apparatus 100. The drawing apparatus 100 irradiates an exposure surface PE of a substrate W on which a photosensitive layer such as a photoresist is formed with drawing light modulated according to predetermined data to expose the photosensitive layer. By this exposure, at least one drawing pattern such as a circuit pattern is drawn. The predetermined data is data representing a pattern, such as computer-aided design (CAD) data. The use of the drawing apparatus 100 enables drawing the pattern directly on the photosensitive layer, in other words, direct drawing. The direct drawing has an advantage that an exposure mask is not required.

The substrate W is, for example, a silicon wafer, a resin substrate, or a glass-quartz substrate. The substrate W is, for example, a semiconductor substrate, a printed board, a substrate for a color filter, a glass substrate for a flat panel display, a substrate for a magnetic disk, a substrate for an optical disk, or a panel for a solar cell. The substrate for a color filter is used in, for example, a liquid crystal display apparatus or the like. The glass substrate for a flat panel display is used in, for example, a liquid crystal display apparatus or a plasma display apparatus. Fig. 2 illustrates a circular semiconductor substrate as the substrate W. Note that a shape of the substrate W is not particularly limited. The substrate W may be formed in, for example, a rectangular shape.

The drawing apparatus 100 may include a main body frame 2. The main body frame 2 constitutes a housing of the drawing apparatus 100. A processing region 3 and a delivery region 4 are formed inside the main body frame 2. The processing region 3 and the delivery region 4 are divided from each other. The drawing apparatus 100 may further include a base 5, a support frame 6, a cassette placement part 7, a stage 10 (substrate holding mechanism), a driving mechanism 20, a stage position measuring part 30, an optical unit 40, a conveyance apparatus 50, and the controller 60. The base 5, the support frame 6, the stage 10, the driving mechanism 20, the stage position measuring part 30, and the optical unit 40 are installed in the processing region 3. The conveyance apparatus 50 is installed in the delivery region 4. The cassette placement part 7 is installed outside the main body frame 2. Hereinafter, a configuration of each part included in the drawing apparatus 100 will be described.

The base 5 supports the stage 10. The support frame 6 is installed on the base 5. The support frame 6 supports the optical unit 40.

The stage 10 holds the substrate W. The stage 10 has a flat plate shape. A placement surface 11 on which the substrate W can be placed is formed on an upper surface of the stage 10. A plurality of suction holes (not illustrated) is formed in the placement surface 11 of the stage 10. As a negative pressure (suction pressure) is formed in the suction holes of the stage 10, the substrate W placed on the placement surface 11 of the stage 10 is fixed to the stage 10. As a result, the stage 10 holds the substrate W.

The driving mechanism 20 is controlled by the controller 60 to relatively move the stage 10 and the head part 402 in the horizontal direction. Specifically, the driving mechanism 20 moves the stage 10 along a main-scanning direction Y, a sub-scanning direction X, and the rotation direction θ. The main-scanning direction Y is a positive-side direction of the Y axis illustrated in Figs. 1 and 2. The sub-scanning direction X is a positive-side direction of the X axis illustrated in Figs. 1 and 2. The rotation direction θ is a rotation direction around the Z axis illustrated in Fig. 2. In the present embodiment, the positive-side direction of the Z axis indicates the upper side in the vertical direction. The placement surface 11 of the stage 10 is parallel to each of the X axis and the Y axis, so that the stage 10 can place the substrate W in a posture along the horizontal direction. In other words, the stage 10 can hold the substrate W on a horizontal plane.

The driving mechanism 20 includes a rotation mechanism 21, a support plate 22, a sub-scanning mechanism 23, a base plate 24, and a main-scanning mechanism 25. The rotation mechanism 21 includes a motor that rotates the stage 10 in order to rotate the substrate W in the horizontal plane. The support plate 22 supports the stage 10 via the rotation mechanism 21. The sub-scanning mechanism 23 moves the support plate 22 along the sub-scanning direction X. The base plate 24 supports the support plate 22 via the sub-scanning mechanism 23. The main-scanning mechanism 25 moves the base plate 24 along the main-scanning direction Y.

The rotation mechanism 21 rotates the stage 10 about a rotation axis A. The rotation axis A is an axis that passes through the center of the stage 10 and is parallel to the Z axis. The rotation mechanism 21 includes, for example, a rotation shaft 211 and a rotational driving part 212. The rotation shaft 211 is fixed to the back side of the placement surface 11 and extends along the Z axis. The rotational driving part 212 includes, for example, a motor. The rotational driving part 212 is provided at a lower end of the rotation shaft 211 and rotates the rotation shaft 211. When the rotational driving part 212 rotates the rotation shaft 211, the stage 10 rotates about the rotation axis A.

The sub-scanning mechanism 23 includes a linear motor 231. The linear motor 231 includes a movable element and a stator. The movable element is attached to a lower surface of the support plate 22. The stator is laid on an upper surface of the base plate 24. A pair of guide members 232 extending in the sub-scanning direction X is laid on the base plate 24. A ball bearing is installed between each of the guide members 232 and the support plate 22. The ball bearing slides along the guide member 232. The support plate 22 is supported by the pair of guide members 232 via the ball bearings. When the linear motor 231 operates, the support plate 22 moves along the sub-scanning direction X while being guided by the guide members 232.

The main-scanning mechanism 25 includes a linear motor 251. The linear motor 251 includes a movable element and a stator. The movable element is attached to a lower surface of the base plate 24. The stator is laid on the base 5 of the drawing apparatus 100. A pair of guide members 252 extending in the main-scanning direction Y is laid on the base 5. For example, an air bearing is installed between each of the guide members 252 and the base plate 24. Air is supplied from utility equipment to the air bearing. The base plate 24 floats on the guide members 252 by the air bearings. As a result, the base plate 24 is supported in a non-contact state with respect to the guide members 252. When the linear motor 251 operates, the base plate 24 moves along the main-scanning direction Y while being guided by the guide member 252. At this time, generation of friction between the base plate 24 and the guide member 252 is avoided.

The stage position measuring part 30 measures a position of the stage 10. The stage position measuring part 30 includes, for example, a laser interferometric length measuring machine. For example, the stage position measuring part 30 emits a laser beam from the outside of the stage 10 toward the stage 10, and receives the laser beam reflected by the stage 10. Then, the stage position measuring part 30 measures the position of the stage 10 from the interference between the laser light emitted toward the stage 10 and the laser light reflected by the stage 10. The position of the stage 10 indicates a position in the main-scanning direction Y and a position in the rotation direction θ.

The conveyance apparatus 50 carries the substrate W into the processing region 3 and carries the substrate W out of the processing region 3. The conveyance apparatus 50 includes a plurality of hands 51 and a hand driving mechanism 52. The hand 51 conveys the substrate W. The hand driving mechanism 52 drives the hand 51. The unprocessed substrate W is accommodated in the cassette placement part 7. The conveyance apparatus 50 takes the substrate W out of the cassette placement part 7 and carries the substrate W into the processing region 3, and carries the processed substrate W out of the processing region 3 and accommodates the processed substrate W in the cassette C.

The optical unit 40 irradiates the substrate W held on the stage 10 with drawing light to draw a pattern on the substrate W. The pattern is a general pattern such as a hole, a trench, and a gate. The optical unit 40 includes a light source part 401 and a head part 402 (drawing head), each of which is controlled by the controller 60. The light source part 401 is installed on the support frame 6. The head part 402 is accommodated inside an attached box attached to the support frame 6.

The light source part 401 includes a laser driving part 41, a laser oscillator 42 (light source), and an illumination optical system 43. The laser oscillator 42 is driven by the laser driving part 41, and emits a spot beam, which is a laser beam, from an output mirror (not illustrated). A wavelength of the laser beam is typically i-line. The spot beam is incident on the illumination optical system 43. The illumination optical system 43 generates linear light from the spot beam. The linear light is a line beam having a substantially uniform intensity distribution and a strip-shaped light flux cross section. The line beam is incident on the head part 402. Hereinafter, the line beam incident on the head part 402 is sometimes described as incident light. Note that it may be configured such that a light amount of the incident light is adjusted by applying an aperture to the incident light at a stage before the incident light is incident on the head part 402.

The incident light is subjected to spatial modulation according to pattern data in the head part 402. Spatially modulating the incident light indicates changing a spatial distribution of the incident light. In general, the spatial distribution of the incident light indicates, for example, an amplitude of the light, a phase of the light, and/or polarization. The spatial distribution of the incident light is generated, for example, by rasterizing the design data of the pattern generated using CAD. The pattern data is information in which information indicating irradiation positions of the drawing light with respect to the substrate W are recorded in units of pixels. The drawing apparatus 100 acquires information indicating the pattern data in advance at the time of a drawing operation, and stores the information in the controller 60.

The head part 402 includes a modulator 44 (specifically, a spatial light modulator), a projection optical system 45, and a mirror 46. The incident light incident on the head part 402 is incident on the modulator 44 at a predetermined angle via the mirror 46. The modulator 44 modulates light from the light source part 401 to generate modulated light. Specifically, the modulator 44 spatially modulates the incident light to be divided into the drawing light and unnecessary light. Out of the modulated light, the drawing light is light that contributes to the pattern drawing, and the unnecessary light is light that does not contribute to the pattern drawing. The projection optical system 45 blocks the unnecessary light out of the modulated light incident from the modulator 44 and guides the drawing light to the substrate W. At this time, the projection optical system 45 focuses the drawing light on a focus position in the height direction over the stage 10. The focus position may be determined with reference to a measurement result by the stage position measuring part 30. The pattern is drawn on the substrate W by moving the stage 10 by the driving mechanism 20 while causing the drawing light to be incident on the substrate W.

### <Details of Modulator>

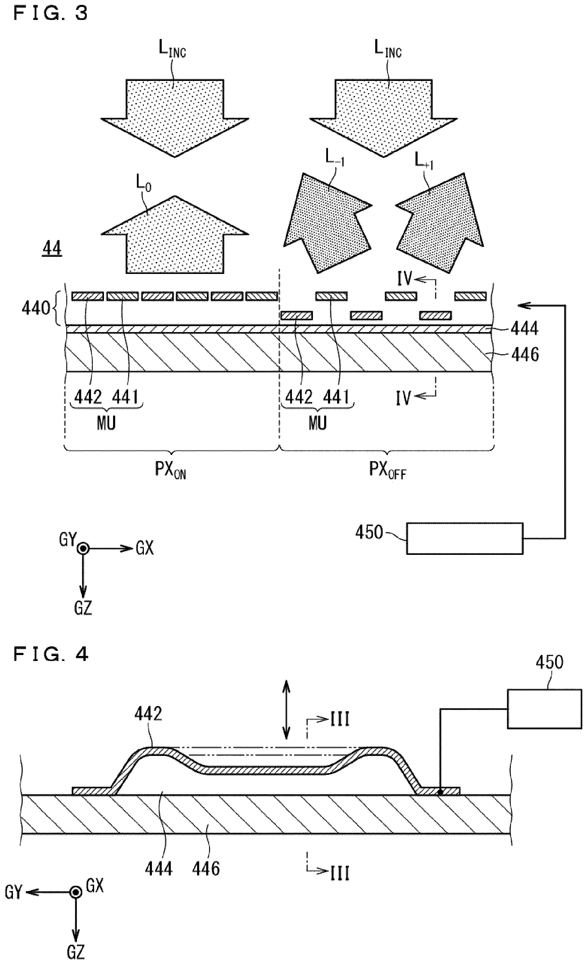

Figs. 3 and 4 are partial cross-sectional views for describing a configuration and an operation principle of the modulator 44. Fig. 3 is a partial cross-sectional view taken along line III-III (Fig. 4), and Fig. 4 is a partial cross-sectional view taken along line IV-IV (Fig. 3).

The modulator 44 includes a diffraction grating 440 formed of a plurality of diffractive elements MU. The plurality of diffractive elements MU is arrayed in an array direction GX along the X direction. The plurality of diffractive elements MU is arrayed only in the array direction GX, and is not arrayed in the other directions. In other words, the plurality of diffractive elements MU is arrayed one-dimensionally instead of two-dimensionally. Thus, the modulator 44 is a one-dimensional modulator. As the one-dimensional modulator, a grating light valve (GLV) ("GLV" is a registered trademark of Silicon Light Machines) which is a micro electro mechanical systems (MEMS) device manufactured using a semiconductor device manufacturing technique is well known, and can be used as the modulator 44 in the present embodiment. Note that a digital mirror device (DMD) is well known as a two-dimensional modulator.

The GLV has a plurality of pixels (modulation units) configured by the diffraction grating 440. Each of the pixels includes at least one diffractive element MU, and typically includes a plurality of diffractive elements MU adjacent to each other. Therefore, the plurality of pixels is arranged in the array direction GX. Fig. 3 illustrates a pixel including three diffractive elements MU. In the drawing, a pixel PX_{ON} is a pixel in an ON state, and a pixel PX_{OFF} is a pixel in an OFF state. These pixels are collectively referred to as pixels PX. Here, the ON state is a state in which zero-order diffracted light L₀ as light contributing to the drawing light is emitted, in other words, a simple specular reflection state. On the other hand, the OFF state is a state in which the light contributing to the drawing light is not emitted, in other words, a state in which ± first-order diffracted light L_{±1} as the unnecessary light is emitted.

The GLV includes the diffraction grating 440, a common electrode 444, a substrate part 446, and a driver circuit unit 450. The diffraction grating 440 includes fixed ribbons 441 and movable ribbons 442 alternately arrayed in the array direction GX. Each of the fixed ribbon 441 and the movable ribbon 442 has a function as a micromirror. One fixed ribbon 441 and one movable ribbon 442 adjacent to each other constitute one diffractive element MU. Each of the fixed ribbon 441 and the movable ribbon 442 has a portion facing the common electrode 444 with an air gap interposed therebetween. A position of the movable ribbon 442 in a depth direction GZ can be controlled by deflection caused by an electrostatic force generated according to a voltage signal from the driver circuit unit 450. The voltage signal can be independently controlled in units of pixels. On the other hand, such a voltage signal is not applied to the fixed ribbon 441, and thus, a depth position of the fixed ribbon 441 is fixed. When an orthogonal direction GY is defined as a direction orthogonal to the array direction GX, each of the fixed ribbon 441 and the movable ribbon 442 extends along the orthogonal direction GY on the air gap in a state where no voltage signal is applied. The array direction GX, the orthogonal direction GY, and the depth direction GZ may be orthogonal to each other.

In the pixel PX_{ON}, as indicated by a two-dot chain line in Fig. 4, the movable ribbon 442 is not deflected, and as a result, a surface of the pixel PX_{ON} becomes a plane formed by the movable ribbons 442 and the fixed ribbons 441. Specifically, the surface of the pixel PX_{ON} is a plane stretching in the array direction GX and the orthogonal direction GY. When the incident light is incident on this plane, the incident light is specularly reflected. In other words, the zero-order diffracted light L₀ is emitted. The zero-order diffracted light L₀ reaches the substrate W as the drawing light. On the other hand, in the pixel PX_{OFF}, the movable ribbon 442 is deflected as illustrated in Fig. 4, and a groove is formed on a surface of the pixel PX_{OFF} as illustrated in Fig. 3. When incident light L_{INC} is incident on this surface, non-zero-order diffracted light, specifically, the ± first-order diffracted light L_{±1} is emitted. The ± first-order diffracted light L_{±1} is blocked as the unnecessary light before reaching the substrate W.

To give a specific configuration of the GLV as an example, 8000 micromirrors (ribbons) are arrayed over a width of 4 mm in the array direction GX, and one pixel PX includes four mirrors (two diffractive elements MU). As a result, 2000 pixels PX are provided in the array direction GX, and the minimum resolution in the width direction GX is 4 mm/2000 = 2 µm.

### <Optical Path in Optical Unit>

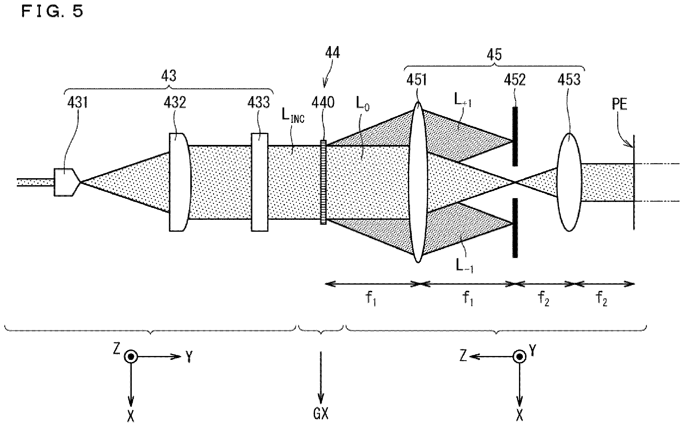

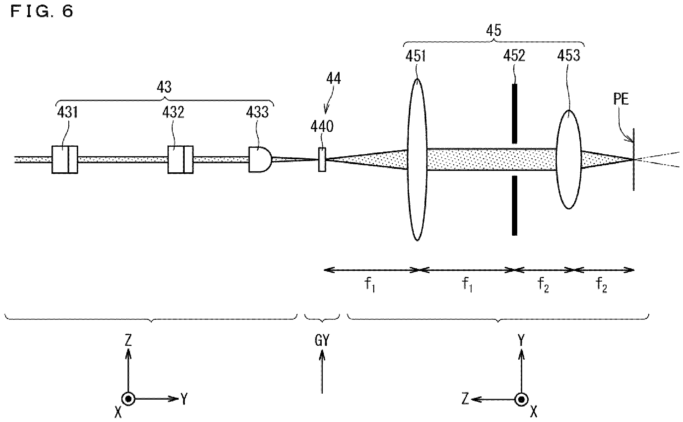

Figs. 5 and 6 are views schematically illustrating an optical path from the light source 42 (see Fig. 1) in the optical unit 40 (Fig. 1). The longitudinal direction in Fig. 5 corresponds to the array direction GX (that is, the X direction) at a position of the modulator 44 for the optical path. The longitudinal direction in Fig. 6 corresponds to a direction orthogonal to the longitudinal direction in Fig. 5. In addition, the lateral direction in each of Figs. 5 and 6 corresponds to a traveling direction of the optical path from left to right, and is not straight in the actual space, and is bent at the mirror 46 and the modulator 44 as illustrated in Fig. 1. Therefore, in order to facilitate understanding of directions, a correspondence relationship of directions among the illumination optical system 43, the modulator 44, and the projection optical system 45 is illustrated in the lower part in Figs. 5 and 6.

The illumination optical system 43 is disposed between the light source 42 (not illustrated in Figs. 5 and 6) and the diffraction grating 440 of the modulator 44. The illumination optical system 43 includes a Powell lens 431 (or a cylinder lens), a collimator lens 432, and a focusing lens 433 in the order of the traveling direction of the optical path. Referring to Fig. 5, the Powell lens 431 diffuses light from the light source to be extended in a linear shape along a direction corresponding to the array direction GX in the diffraction grating 440, that is, the X direction in the illumination optical system 43. The collimator lens 432 adjusts the diffused light from the Powell lens 431 to parallel light (collimated light) in the direction corresponding to the array direction GX in the diffraction grating 440, that is, the X direction in the illumination optical system 43. The focusing lens 433 substantially focuses the parallel light from the collimator lens 432 on the modulator 44 in the direction corresponding to the orthogonal direction GY (Fig. 6) in the diffraction grating 440, and transmits the parallel light as it is in the direction corresponding to the array direction GX (Fig. 5) in the diffraction grating 440. Therefore, the illumination optical system 43 supplies the light from the light source to the diffraction grating 440 as the parallel light in the array direction GX. On the other hand, the illumination optical system 43 supplies the light from the light source to the diffraction grating 440 as non-parallel light (specifically, convergent light) in the orthogonal direction GY.

The projection optical system 45 is disposed between the diffraction grating 440 of the modulator 44 and the exposure surface PE. The projection optical system 45 includes a Fourier transform lens 451, a Fourier filter 452, and an inverse Fourier transform lens 453 (objective lens) in the order of the traveling direction of the optical path between the modulator 44 and the exposure surface PE. A magnification that can be obtained by the objective lens is determined by a ratio f₂/f₁, where f₁ is a focal length of the Fourier transform lens 451 and f₂ is a focal length of the inverse Fourier transform lens 453. The Fourier filter 452 is a filter that blocks the ± first-order diffracted light L_{±1} having passed through the Fourier transform lens 451 while transmitting the zero-order diffracted light L₀ of the diffraction grating 440 having passed through the Fourier transform lens 451, and specifically, is a blocking plate having an aperture that transmits the zero-order diffracted light L₀. Drawing is performed by irradiating the exposure surface PE with light emitted from the inverse Fourier transform lens 453. Two-dot chain lines drawn rightward beyond the exposure surface PE in Figs. 5 and 6 are virtual extension lines of the optical paths. As can be seen from these optical paths, the degree of parallelism of the light emitted from the inverse Fourier transform lens 453, which is the objective lens, is low in the Y direction (Fig. 6), but in the X direction (Fig. 5), is relatively high as compared with the Y direction (Fig. 6), and preferably, is substantially parallel light.

### <Hardware Configuration of Controller>

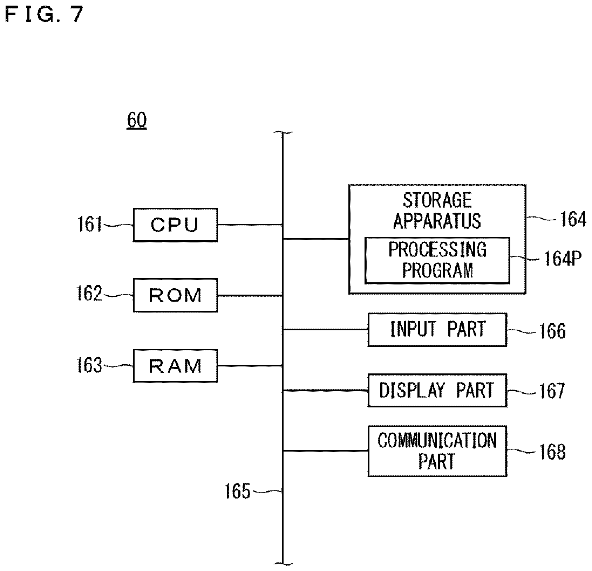

Fig. 7 is a block diagram illustrating a hardware configuration of the controller 60. The controller 60 may be configured using one or a plurality of general computers having an electric circuit. In a case where a plurality of computers is used, the computers are connected to be capable of communicating with each other. The controller 60 may be disposed in one electric rack (not illustrated). Specifically, the controller 60 includes a central processing unit (CPU) 161, a read only memory (ROM) 162, a random access memory (RAM) 163, a storage apparatus 164, an input part 166, a display part 167, a communication part 168, and a bus line 165 that connects these to one another. The ROM 162 stores a basic program. The RAM 163 is used as a work area when the CPU 161 performs predetermined processing. The storage apparatus 164 includes a non-volatile storage apparatus such as a flash memory or a hard disk apparatus. The input part 166 includes various switches, a touch panel, a recording medium reading apparatus, or the like, and receives an input setting instruction such as a processing recipe from an operator. The display part 167 includes, for example, a liquid crystal display apparatus, a lamp, and the like, and displays various types of information under the control of the CPU 161. The communication part 168 has a data communication function via a local area network (LAN) or the like. In the storage apparatus 164, a plurality of modes regarding control of each configuration in the drawing apparatus 100 are set in advance. When the CPU 161 executes a processing program 164P, one of the plurality of modes is selected, and each configuration is controlled in the mode. Note that the processing program 164P may be stored in a recording medium. When this recording medium is used, the processing program 164P can be installed in the controller 60. In addition, some or all of the functions executed by the controller 60 are not necessarily implemented by software, and may be implemented by hardware such as a dedicated logic circuit.

### <Exposure Scanning>

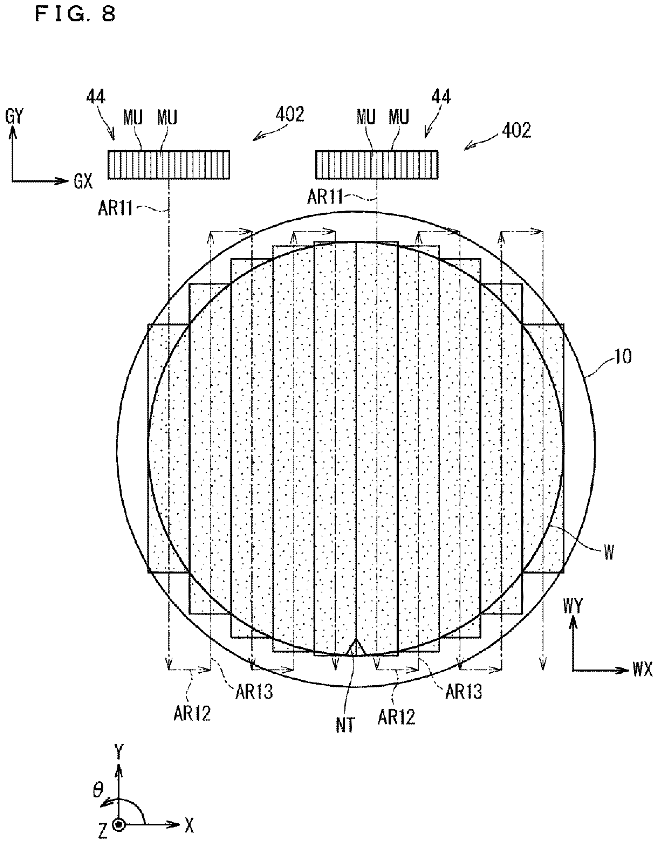

Fig. 8 is a plan view schematically illustrating exposure scanning in a first mode in a drawing method according to the present embodiment. In this exposure scanning, the substrate W is subjected to exposure scanning. A main surface of the substrate W has a substrate orientation WX and a substrate orientation WY orthogonal to each other. In a state where the substrate W is held on the stage 10 (Figs. 1 and 2), each of the substrate orientation WX and the substrate orientation WY is an orientation in the XY plane. The substrate W may have a notch or an orientation flat such that the substrate orientation thereof can be easily determined, and is provided with a notch NT on the negative side in the substrate orientation WY in the illustrated example. In the first mode, after an orientation of the substrate W is adjusted such that the substrate orientation WX of the substrate W is along the X direction, the following exposure scanning is performed. Note that a case where two head parts 402 are used is illustrated in the drawing, but any number of the head parts 402 may be used.

In the exposure scanning, the driving mechanism 20 moves the stage 10 in a forward direction (here, exemplified as the +Y direction) along the main-scanning direction (Y direction) to relatively move the substrate W along a main-scanning axis with respect to each of the head parts 402 (forward main-scanning). When viewed from the substrate W, each of the head parts 402 traverses the substrate W in the -Y direction along the main-scanning axis as indicated by an arrow AR11. In addition, as the forward main-scanning is started, the drawing light is emitted from each of the head parts 402. That is, pattern data (specifically, a portion, which describes data that needs to be drawn in a stripe region to be drawn by the forward main-scanning, of the pattern data) is read, and the modulator 44 is controlled according to the pattern data. Then, drawing light subjected to spatial modulation according to the pattern data is emitted from each of the head parts 402 toward the substrate W.

When each of the head parts 402 traverses the substrate W once along the main-scanning axis while emitting the drawing light continuously or intermittently toward the substrate W, a pattern group is drawn in one stripe region (region extending along the main-scanning axis and having a width along a sub-scanning axis corresponding to a width of the drawing light). Here, pattern groups are drawn in two stripe regions, respectively, by one forward main-scanning since the two head parts 402 simultaneously traverse the substrate W.

When the forward main-scanning involving the irradiation of the drawing light is completed, the driving mechanism 20 moves the stage 10 in a predetermined direction (for example, in the -X direction) along the sub-scanning direction (X direction) by a distance corresponding to the width of the drawing light. Accordingly, the substrate W moves relative to each of the head parts 402 along the sub-scanning direction (sub-scanning). When viewed from the substrate W, each of the head parts 402 moves in the +X direction along the sub-scanning direction by the width of the stripe region as indicated by an arrow AR12.

When the sub-scanning is completed, backward main-scanning involving the irradiation of the drawing light is executed. That is, the driving mechanism 20 moves the stage 10 in the backward direction (here, in the -Y direction,) along the main-scanning direction (Y direction). Accordingly, the substrate W moves relative to each of the head parts 402 along the main-scanning direction (backward main-scanning). When viewed from the substrate W, each of the head parts 402 moves in the +Y direction along the main-scanning direction on the substrate W to traverse the substrate W as indicated by an arrow AR13. In the meantime, when the backward main-scanning is started, the irradiation of the drawing light is started from each of the head parts 402. This backward main-scanning causes pattern groups to be drawn in stripe regions respectively adjacent to the stripe regions subjected to the drawing in the previous forward main-scanning.

When the backward main-scanning involving the irradiation of the drawing light ends, sub-scanning is performed, and then, the forward main-scanning involving the irradiation of the drawing light is performed again. This forward main-scanning causes pattern groups to be drawn in stripe regions respectively adjacent to the stripe regions subjected to the drawing in the previous backward main-scanning. Thereafter, similarly, the main-scanning involving the irradiation of the drawing light is repeatedly performed while interposing the sub-scanning, and when the pattern is drawn in the entire region of the drawing target region, the drawing processing for one piece of the pattern data ends.

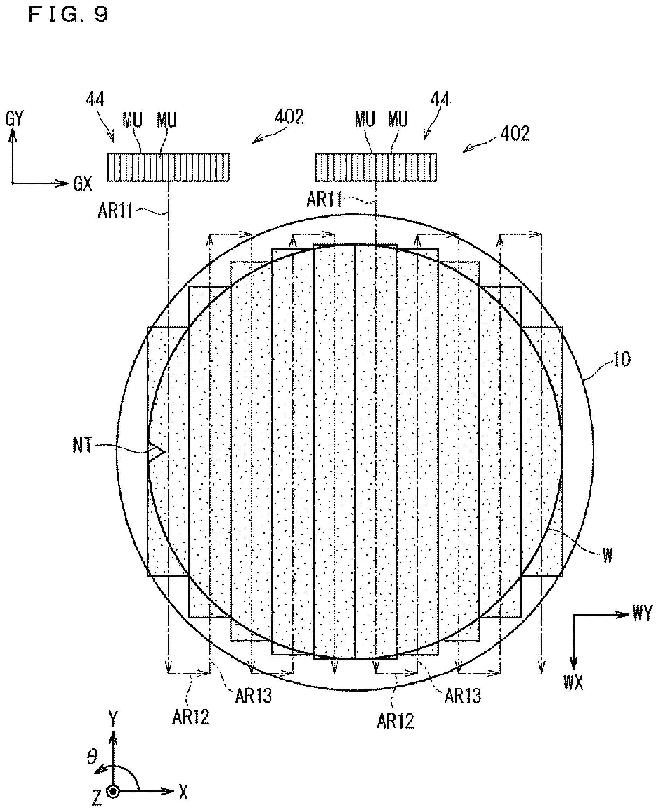

Fig. 9 is a plan view schematically illustrating exposure scanning in a second mode in the drawing method according to the present embodiment. In the second mode, exposure scanning similar to that in the case of Fig. 8 is performed after an orientation of the substrate W is adjusted such that the substrate orientation WY of the substrate W is along the X direction.

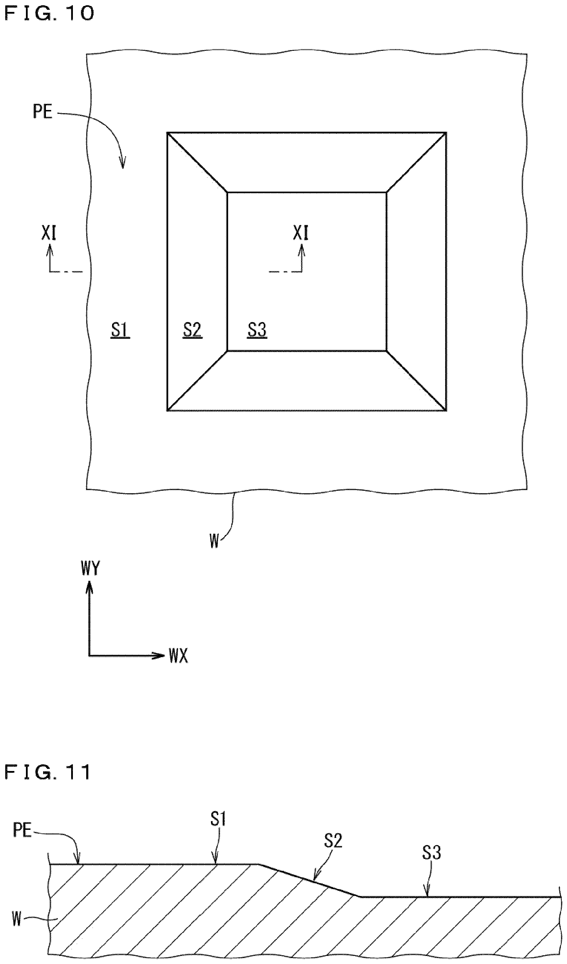

Fig. 10 is a partial plan view exemplifying the exposure surface PE of the substrate W, and Fig. 11 is a partial cross-sectional view taken along line XI-XI (Fig. 10). The exposure surface PE is provided with at least one stepped structure having a step upper surface S1, a step lower surface S3 having a height lower than that of the step upper surface S1, and an inclined surface S2 connecting the step upper surface S1 and the step lower surface S3 to each other. A height difference of the stepped structure may exceed a DOF of the drawing apparatus 100 and may be 100 µm or more. At least one drawing pattern to be drawn in the present embodiment includes at least one stepped pattern. The stepped pattern is a drawing pattern drawn at least partially on the inclined surface S2 of a step, and extends in a longitudinal direction in a plan view (a field of view in Fig. 10). The stepped pattern may be a drawing pattern traversing the inclined surface S2 between the step upper surface S1 and the step lower surface S3. In other words, the stepped pattern may be a drawing pattern extending from the step upper surface S1 to the step lower surface S3 via the inclined surface S2.

### <Application Example>

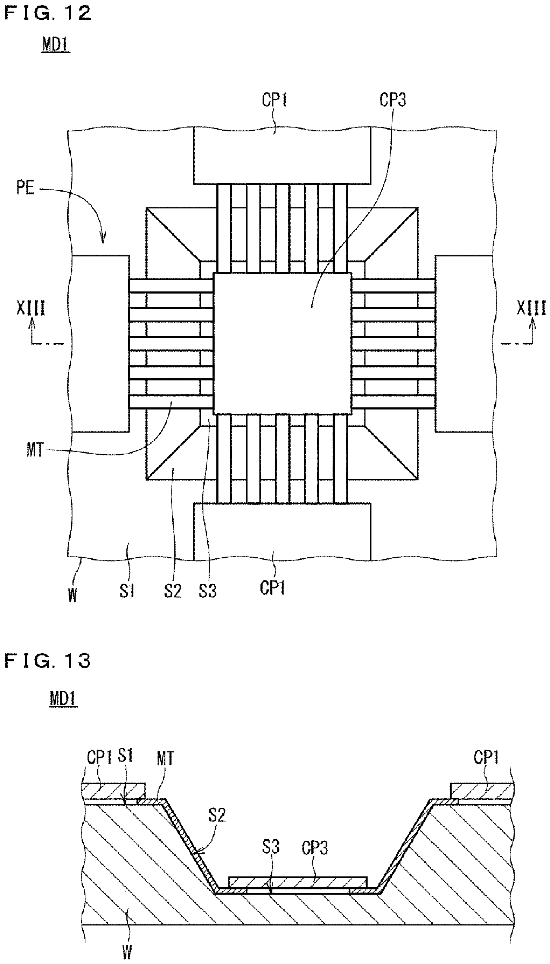

Fig. 12 is a partial plan view illustrating a semiconductor module MD1 as an example of an apparatus that requires drawing of the above-described stepped pattern in manufacturing. Fig. 13 is a partial cross-sectional view taken along line XIII-XIII (Fig. 12). The semiconductor module MD1 has upper surface wiring MT formed on an upper surface of the substrate W by a photolithography step using drawing of the stepped pattern. The upper surface wiring MT traverses the inclined surface S2 between the step upper surface S1 and the step lower surface S3. Since the upper surface wiring MT is used, a semiconductor chip CP1 on the step upper surface S1 and a semiconductor chip CP3 on the step lower surface S3 can be electrically connected to each other.

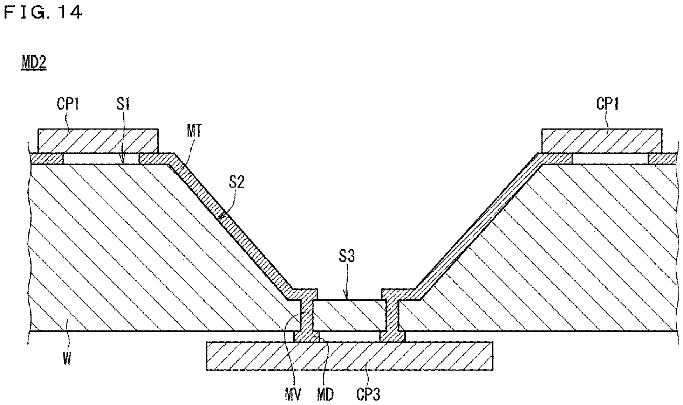

Fig. 14 is a partial cross-sectional view illustrating a semiconductor module MD2 as a modification of the semiconductor module MD1 (Fig. 13). In the semiconductor module MD2, the semiconductor chip CP3 is disposed on the opposite side of the step lower surface S3 of the substrate W. The semiconductor chip CP3 and the upper surface wiring MT are connected via through wiring MV passing through the substrate W and back surface wiring MD provided on a back surface of the substrate W.

### <Function of Controller>

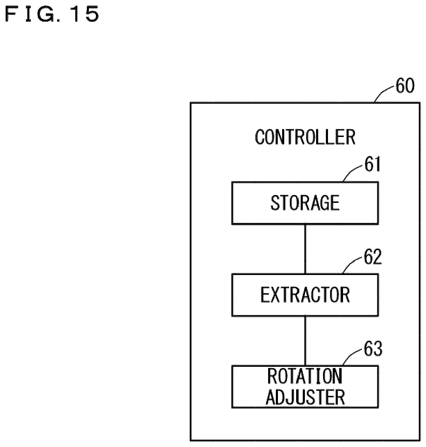

Fig. 15 is a functional block diagram schematically illustrating a configuration of the controller 60 (Fig. 1). The controller 60 includes a storage 61, an extractor 62, and a rotation adjuster 63.

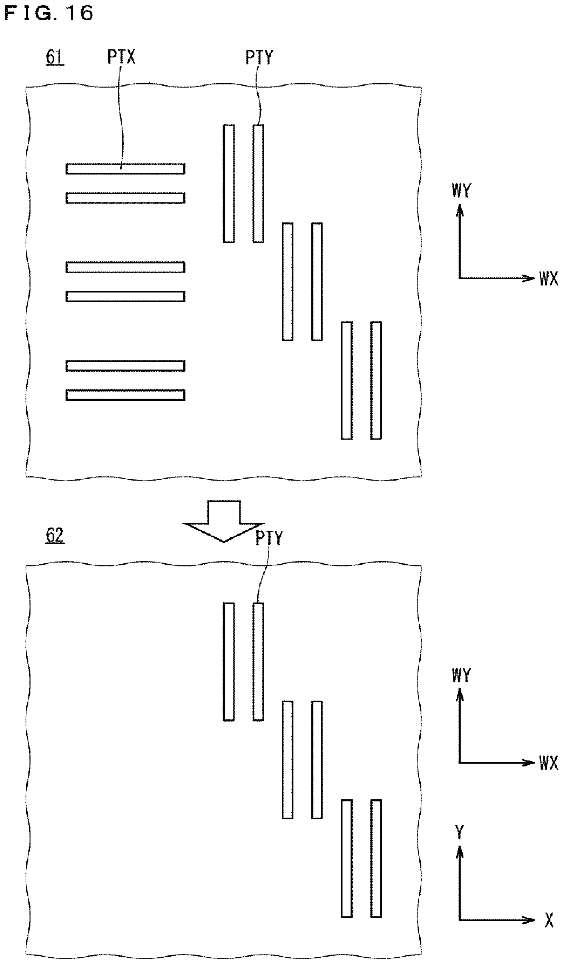

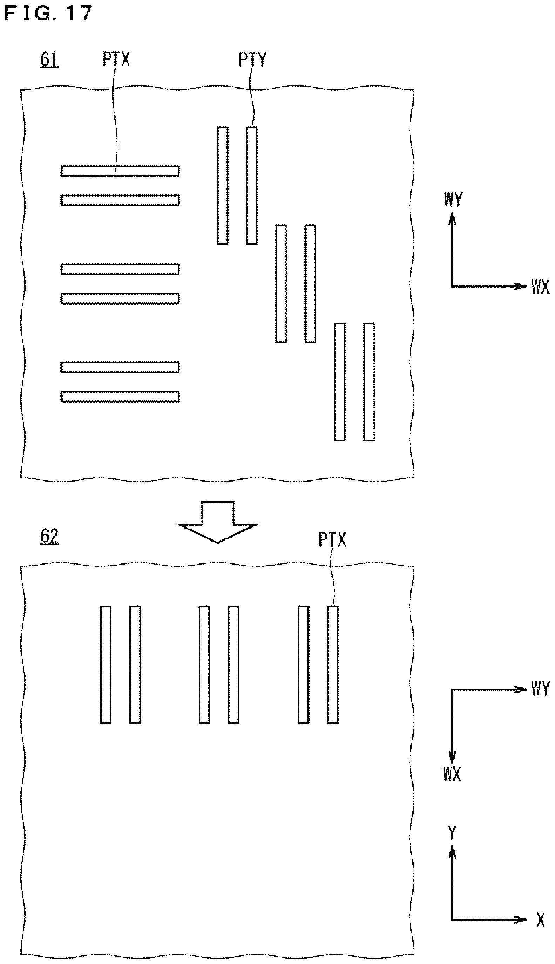

The storage 61 stores data representing a drawing pattern to be drawn on the substrate W. For example, as illustrated in the upper part of Fig. 16 (or Fig. 17), the storage 61 stores a drawing pattern PTX having a longitudinal direction along the substrate orientation WX in a plan view and a drawing pattern PTY having a longitudinal direction along the substrate orientation WY in a plan view. At least one drawing pattern is the above-described stepped pattern. At least one drawing pattern PTX may be the stepped pattern, and at least one drawing pattern PTY may be the stepped pattern. Such cases will be described hereinafter. In addition, these stepped patterns are also referred to as the stepped pattern PTX and the stepped pattern PTY using the same reference signs as the drawing pattern PTX and the drawing pattern PTY.

As illustrated in Fig. 16, the extractor 62 extracts, as first pattern data, data representing a stepped pattern having a longitudinal direction within a first allowable angle range with the substrate orientation WY (a first substrate orientation) as a reference, among the stepped patterns. As a result, the stepped pattern PTY is extracted. Note that the first allowable angle range may be zero in the illustrated example. However, in a case where stepped patterns having various longitudinal directions exist together, the first allowable angle range may be appropriately set, and the range is, for example, within ± 10 degrees.

In addition, as illustrated in Fig. 17, the extractor 62 extracts, as second pattern data, data representing a stepped pattern having a longitudinal direction within a second allowable angle range with the substrate orientation WX (a second substrate orientation orthogonal to the first substrate orientation) as a reference, among the stepped patterns. As a result, the stepped pattern PTX is extracted. Note that the second allowable angle range may be zero in the illustrated example. However, in a case where stepped patterns having various longitudinal directions exist together, the second allowable angle range may be appropriately set, and the range is, for example, within ± 10 degrees. The second allowable angle range may be the same as the first allowable angle range.

Note that, as a modification, the extractor 62 may extract, as third pattern data, data representing a stepped pattern having a longitudinal direction within a third allowable angle range with a third substrate orientation, which is a substrate orientation between the substrate orientation WX and the substrate orientation WY, as a reference, among the stepped patterns. The third substrate orientation may be, for example, a substrate orientation rotated clockwise by 45 degrees from the substrate orientation WY. In this case, exposure scanning in a third mode in which the substrate W has an intermediate orientation between the case of the first mode (Fig. 8) and the case of the second mode (Fig. 9) is also performed.

The rotation adjuster 63 (Fig. 15) adjusts the orientation of the substrate W on the horizontal plane by controlling the rotation mechanism 21 (Figs. 1 and 2). This adjustment is performed such that a longitudinal direction of a stepped pattern extracted by the extractor 62 substantially coincides with the Y direction in a plan view (a field of view on the XY plane). Specifically, in the case of Fig. 16, the adjustment is performed such that the substrate orientation WY corresponding to the longitudinal direction of the stepped pattern PTY substantially coincides with the Y direction. In addition, in the case of Fig. 17, the adjustment is performed such that the substrate orientation WX corresponding to the longitudinal direction of the stepped pattern PTX substantially coincides with the Y direction. Note that the degree of the substantial coincidence corresponds to the above-described allowable angle range. Here, a projection of the orthogonal direction GY (Fig. 1) of the diffraction grating 440 of the modulator 44 onto the horizontal plane (that is, the XY plane) coincides with the Y direction. In other words, the above adjustment is adjustment performed such that the longitudinal direction of the stepped pattern extracted by the extractor 62 substantially coincides with the orthogonal direction GY of the diffraction grating 440 in the plan view.

### <Drawing Method>

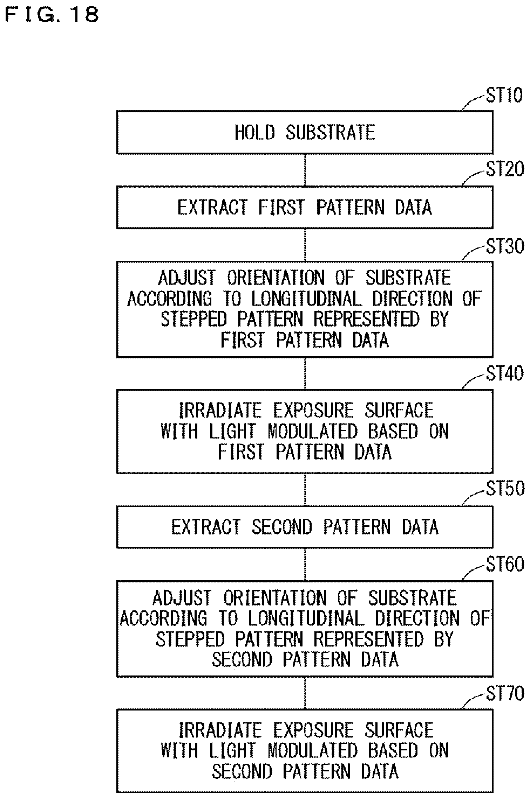

Next, the drawing method in the present embodiment will be exemplified. Fig. 18 is a flowchart schematically illustrating the drawing method.

In step ST10 (Fig. 11), the substrate W is held on the horizontal plane (XY plane) by the stage 10 (Figs. 1 and 2). In addition, data representing a drawing pattern to be drawn is stored in the storage 61 (Fig. 15) of the controller 60.

In step ST20 (Fig. 11), pattern data corresponding to the stepped pattern PTY is extracted as described above with reference to Fig. 16. In step ST30 (Fig. 11), the orientation of the substrate W on the horizontal plane is adjusted according to the substrate orientation WY corresponding to the longitudinal direction of the stepped pattern PTY as illustrated in the lower part of Fig. 16. This adjustment is performed such that the substrate orientation WY corresponding to the longitudinal direction of the stepped pattern PTY substantially coincides with the Y direction in a plan view as described above. As a result, a state where the exposure scanning in the first mode illustrated in Fig. 8 can be started is obtained.

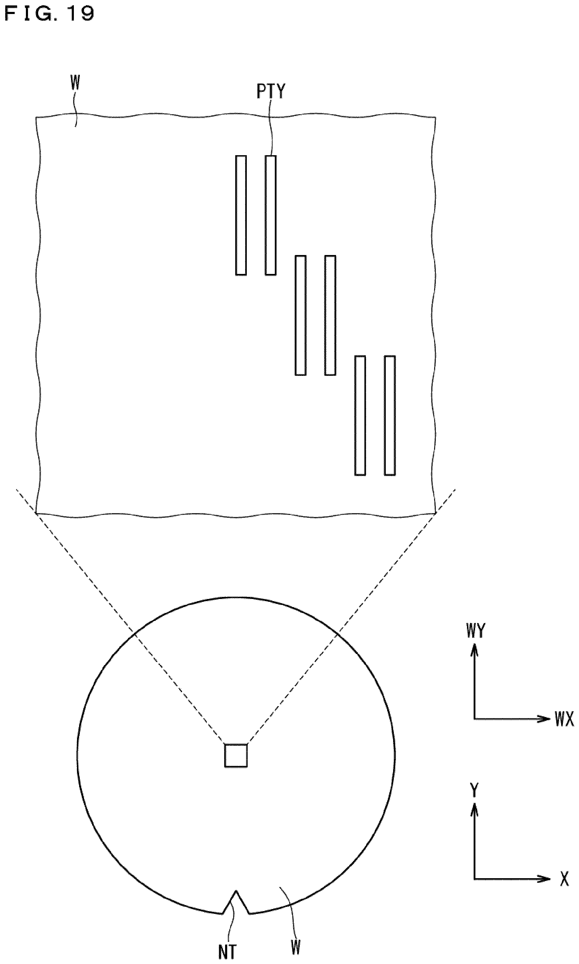

In step ST40 (Fig. 11), the substrate W is irradiated with light modulated by the modulator 44 by the exposure scanning in the first mode (Fig. 8). As a result, the stepped pattern PTY is drawn as illustrated in Fig. 19. Note that, in each of Fig. 19 and Figs. 20 and 21 to be described later, the upper part is an enlarged view of a rectangular portion in the lower part.

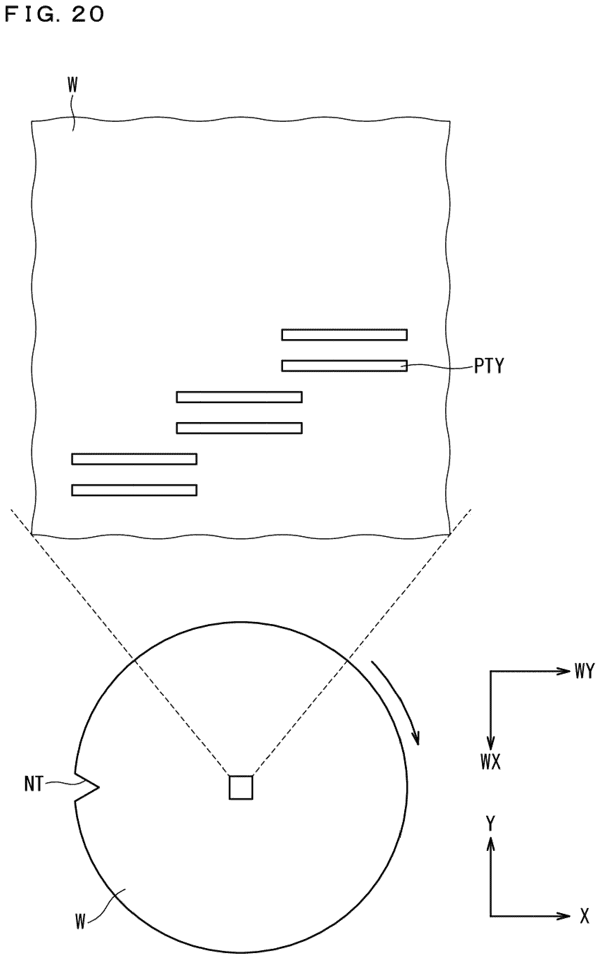

In step ST50 (Fig. 11), pattern data corresponding to the stepped pattern PTX is extracted as described above with reference to Fig. 17. In step ST60 (Fig. 11), the orientation of the substrate W on the horizontal plane is adjusted according to the substrate orientation WX corresponding to the longitudinal direction of the stepped pattern PTX as illustrated in the lower part of Fig. 17. This adjustment is performed such that the substrate orientation WX corresponding to the longitudinal direction of the stepped pattern PTX substantially coincides with the Y direction in a plan view as described above. Specifically, the substrate W is rotated by 90 degrees as indicated by an arrow in Fig. 20. As a result, a state where the exposure scanning in the second mode illustrated in Fig. 9 can be started is obtained.

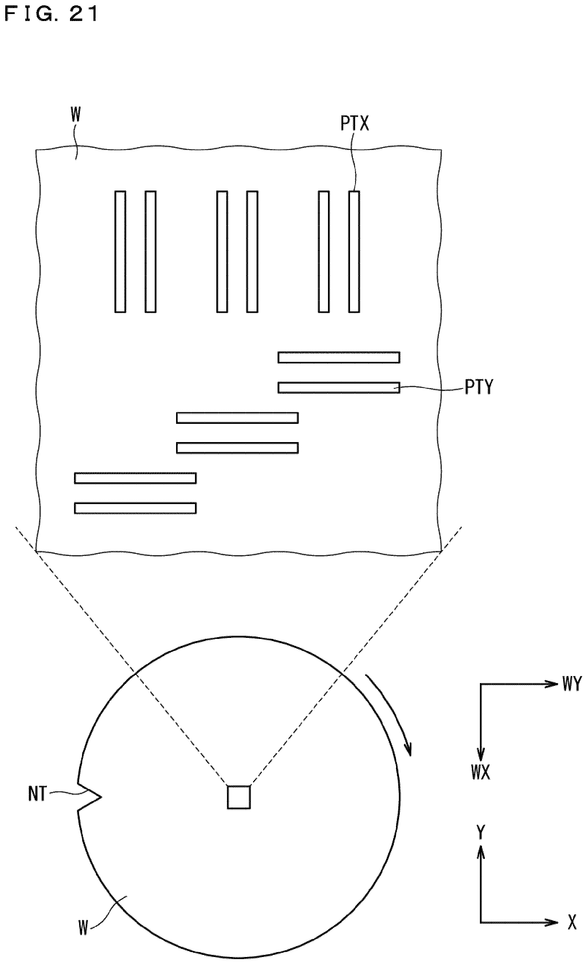

In step ST70 (Fig. 11), the substrate W is irradiated with light modulated by the modulator 44 by the exposure scanning in the second mode (Fig. 9). As a result, the stepped pattern PTX is drawn as illustrated in Fig. 21.

As described above, both the stepped pattern PTX and the stepped pattern PTY are drawn. A drawing pattern other than the stepped pattern PTX and the stepped pattern PTY may be drawn simultaneously by either the exposure scanning in the first mode or the exposure scanning in the second mode.

In each exposure scanning described above, a focus position of the modulated light (a focus position at a right end of the optical path illustrated in Fig. 6) may be fixed at a certain reference height. In this case, referring to Fig. 1, a distance in the height direction between the head part 402 and the stage 10 is maintained constant. Referring to Fig. 11, the reference height may be a height position of the step upper surface S1 or a height position of the step lower surface S3, but is preferably a height position therebetween, and more preferably a middle height position therebetween. The focus position may be fixed at the reference height even in a period in which the exposure scanning traverses the inclined surface S2 between the step upper surface S1 and the step lower surface S3. In other words, in the present embodiment, adjustment of the focus position is not necessarily required even in the period in which the exposure scanning traverses the inclined surface S2 between the step upper surface S1 and the step lower surface S3.

### <Comparative Example>

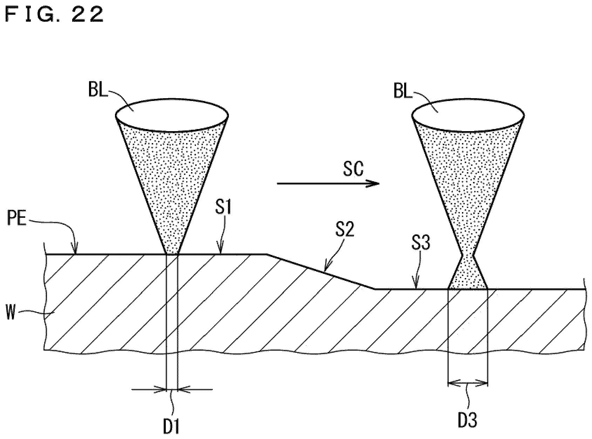

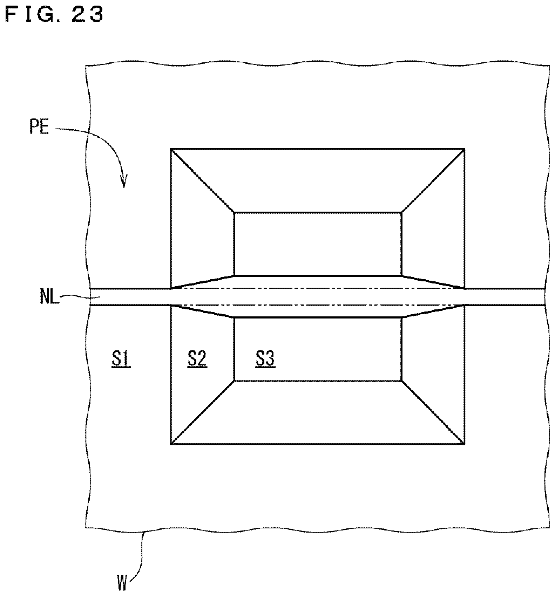

Fig. 22 is a partial cross-sectional view schematically illustrating a state of exposure scanning SC using a two-dimensional modulator such as a DMD as a first comparative example. If a height position of the step upper surface S1 is adopted as a focus position in a case where drawing with a width D1 is intended, desired exposure can be performed on the step upper surface S1, but exposure with a width D3 larger than the width D1 is performed on the step lower surface S3 due to defocus. As a result, the drawing accuracy is deteriorated. Specifically, in a case where a photosensitive layer is a negative resist layer, as illustrated in a partial plan view of Fig. 23, a width of a resist pattern NL becomes unintentionally larger than a desired width indicated by a two-dot chain line on the step lower surface S3. This problem is solved if high accuracy autofocus can be executed during the exposure scanning SC. However, such autofocus requires complicated control, and such control is practically difficult in a case where a height difference is large (particularly, 100 µm or more).

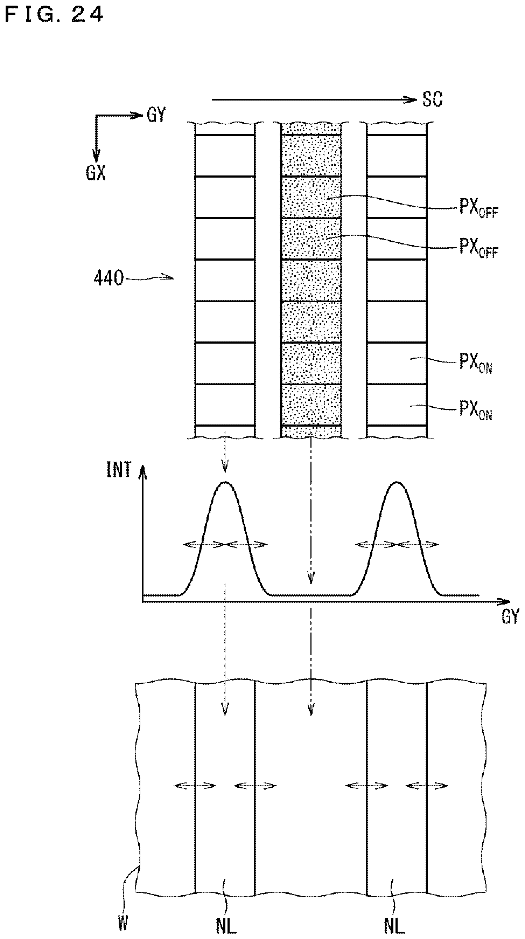

Fig. 24 is a view illustrating a method of forming line-and-space (L/S) of the resist pattern NL by repeating ON and OFF of the pixel PX of the modulator 44 during the exposure scanning SC as a second comparative example. In the exposure scanning SC, the L/S of the resist pattern NL can be formed by repeating ON and OFF collectively for a plurality of adjacent pixels PX. In this case, an exposure light amount INT has a Gaussian shape in the orthogonal direction GY corresponding to the width direction of the L/S. Furthermore, the Gaussian shape has a high dependence on defocus on the exposure surface PE (Fig. 6) as indicated by an arrow in Fig. 24 for a reason similar to that in the comparative example in Figs. 22 and 23 described above. Thus, the width of the resist pattern NL greatly varies due to the defocus.

### <Effect>

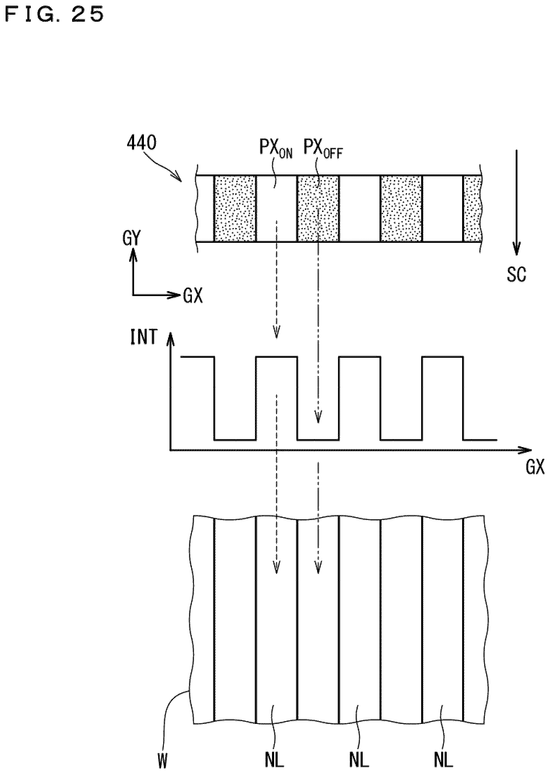

Fig. 25 is a view for describing the method of forming line-and-space (L/S) of the resist pattern NL by the exposure scanning SC in the present embodiment. This exposure scanning SC is performed while maintaining a state in which at least one pixel PX_{ON} and at least one pixel PX_{OFF} are repeatedly arrayed in the modulator 44. In this case, the exposure light amount INT has a top hat shape as illustrated in the middle part of Fig. 25 in the array direction GX corresponding to the width direction of L/S. The top hat shape has a low dependence on defocus on the exposure surface PE (Fig. 5). Thus, a width of the resist pattern NL is less likely to undergo a variation due to the defocus. Thus, as illustrated in Fig. 25, the orientation of the substrate W is adjusted such that a longitudinal direction of a line pattern is orthogonal to the array direction GX, whereby the pattern can be drawn with high accuracy even on the exposure surface PE having the height difference exceeding the DOF. At that time, it is unnecessary to complicatedly adjust the focus of the optical system. Furthermore, it is possible to draw line patterns having different longitudinal directions with high accuracy by changing the orientation of the substrate W and performing the exposure scanning SC a plurality of times.

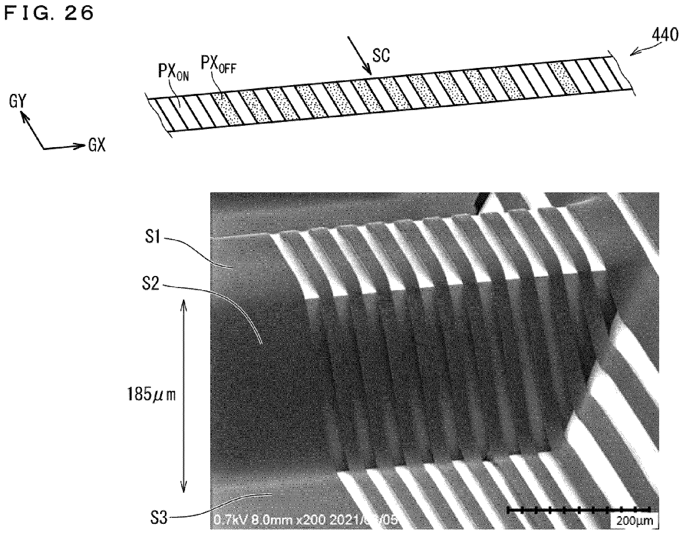

Fig. 26 is a photomicrograph showing an example of the drawing method described in Fig. 25. The height difference between the step upper surface S 1 and the step lower surface S3 was 185 µm. A line pattern of a negative resist layer was drawn with high accuracy with a constant width of 20 µm in width from the step upper surface S 1 to the step lower surface S3 via the inclined surface S2.

Note that the case where the drawing pattern has the L/S shape has been described in Figs. 25 and 26, but the shape of the drawing pattern is not limited thereto. In addition, the case where the negative resist is used has been exemplified, but a positive resist may be used instead of the negative resist.

### EXPLANATION OF REFERENCE SIGNS

- 10:: stage
- 21:: rotation mechanism
- 40:: optical unit
- 42:: laser oscillator (light source)
- 43:: illumination optical system
- 44:: modulator
- 45:: projection optical system
- 46:: mirror
- 60:: controller
- 61:: storage
- 62:: extractor
- 63:: rotation adjuster
- 100:: drawing apparatus
- 401:: light source part
- 402:: head part
- 431:: Powell lens
- 432:: collimator lens
- 433:: focusing lens
- 440:: diffraction grating
- 441:: fixed ribbon
- 442:: movable ribbon
- 450:: driver circuit unit
- 451:: Fourier transform lens
- 452:: Fourier filter
- 453:: inverse Fourier transform lens
- GX:: array direction
- GY:: orthogonal direction
- NL:: resist pattern
- PE:: exposure surface
- PTX:: drawing pattern, stepped pattern
- PTY:: drawing pattern, stepped pattern
- PX:: pixel
- S 1:: step upper surface
- S2:: inclined surface
- S3:: step lower surface
- SC:: exposure scanning
- W:: substrate

## Claims

1. A drawing apparatus that draws at least one drawing pattern on an exposure surface of a substrate, said exposure surface being provided with at least one stepped structure including a step upper surface, a step lower surface having a lower height than said step upper surface, and an inclined surface connecting said step upper surface and said step lower surface to each other, said at least one drawing pattern including at least one stepped pattern drawn at least partially on said inclined surface of said stepped structure, and said at least one stepped pattern extending in a longitudinal direction in a plan view, said drawing apparatus comprising:
a substrate holding mechanism that holds said substrate on a horizontal plane;
a light source;
a modulator that includes a diffraction grating including a plurality of diffractive elements arrayed in an array direction and modulates light from said light source;
a projection optical system including an objective lens disposed between said exposure surface and said modulator;
a rotation mechanism that rotates said substrate in said horizontal plane; and
a controller that controls said rotation mechanism to adjust an orientation of said substrate on said horizontal plane in such a manner that said longitudinal direction of said at least one stepped pattern substantially coincides with an orthogonal direction orthogonal to said array direction of said diffraction grating in the plan view.

2. The drawing apparatus according to claim 1, further comprising
an illumination optical system provided between said light source and said diffraction grating, said illumination optical system supplying said light from said light source to said diffraction grating as parallel light in said array direction.

3. The drawing apparatus according to claim 1 or 2, wherein said plurality of diffractive elements is arrayed only in said array direction.

4. The drawing apparatus according to any one of claims 1 to 3, wherein said controller includes an extractor that extracts, as first pattern data, data representing a stepped pattern having a longitudinal direction within a first allowable angle range with a first substrate orientation of said substrate as a reference, among said at least one stepped pattern.

5. The drawing apparatus according to claim 4, wherein said first allowable angle range is within ± 10 degrees.

6. The drawing apparatus according to claim 4 or 5, wherein said extractor extracts, as second pattern data, data representing a stepped pattern having a longitudinal direction within a second allowable angle range with a second substrate orientation, different from said first substrate orientation, of said substrate as a reference, among said at least one stepped pattern.

7. The drawing apparatus according to claim 6, wherein said second substrate orientation is orthogonal to said first substrate orientation.

8. A drawing method of drawing at least one drawing pattern on an exposure surface of a substrate, said exposure surface being provided with at least one stepped structure including a step upper surface, a step lower surface having a lower height than said step upper surface, and an inclined surface connecting said step upper surface and said step lower surface to each other, said at least one drawing pattern including at least one stepped pattern drawn at least partially on said inclined surface of said stepped structure, and said at least one stepped pattern extending in a longitudinal direction in a plan view, said drawing method comprising the steps of:
(a) holding said substrate on a horizontal plane;
(b) adjusting an orientation of said substrate on said horizontal plane; and
(c) irradiating, via an objective lens, said exposure surface with light modulated by a modulator which includes a diffraction grating including a plurality of diffractive elements arrayed in an array direction,
wherein said (b) is performed in such a manner that said longitudinal direction of said at least one stepped pattern substantially coincides with a direction orthogonal to said array direction of said diffraction grating in the plan view.
